(19) Europäisches Patentamt / European Patent Office / Office européen des brevets

(11)  **EP 1 909 321 B1**

(12)  **EUROPEAN PATENT SPECIFICATION**

(45) Date of publication and mention
of the grant of the patent:
**17.08.2011  Bulletin 2011/33**

(51) Int Cl.:
*H01L 23/12* (2006.01)          *H01L 23/36* (2006.01)
*H01S 5/022* (2006.01)

(21) Application number: **06756534.1**

(22) Date of filing: **24.05.2006**

(86) International application number:
**PCT/JP2006/310328**

(87) International publication number:
**WO 2006/132087 (14.12.2006 Gazette 2006/50)**

(54) **METAL-CERAMIC COMPOSITE SUBSTRATE AND METHOD FOR MANUFACTURING SAME**

METALL-KERAMIK-VERBUNDSUBSTRAT UND VERFAHREN ZU SEINER HERSTELLUNG

SUBSTRAT COMPOSITE METAL-CERAMIQUE ET SON PROCEDE DE FABRICATION

(84) Designated Contracting States:
**DE**

(30) Priority:  **06.06.2005   JP 2005166162**

(43) Date of publication of application:
**09.04.2008   Bulletin 2008/15**

(60) Divisional application:
**10005899.9 / 2 224 479**

(73) Proprietor: **DOWA Electronics Materials Co., Ltd.
Chiyoda-ku
Tokyo 101-0021 (JP)**

(72) Inventor: **OSHIKA, Yoshikazu,
DOWA ELECTRONICS MATERIALS CO., LTD.
Tokyo 1010021 (JP)**

(74) Representative: **Marshall, John Grahame
Serjeants
25 The Crescent
King Street
Leicester LE1 6RX (GB)**

(56) References cited:
EP-A- 1 705 966      WO-A-2004/093186
JP-A- 2004 031 485   JP-A- 2004 031 485
JP-A- 2004 119 515   JP-A- 2004 119 515
JP-A- 2004 288 935   US-A- 4 412 377

**Description**

Technical Field

The present invention relates to a metal-ceramic composite substrate for use as an electronic circuit board and a method of manufacturing the same.

Background Art

Generally, an electronic component of one of various kinds is mounted at a selected site on a copper wiring pattern formed on a printed board and is soldered thereon to complete a connection of electronic circuitry. However, a variety of resins such as paper phenol, epoxy and glass epoxy resins used as materials of the printed board are poor in heat dissipation though reducing the cost.

Patent Reference 1 discloses a semiconductor mounted circuit board for high-density packaging in which insulating filler is poured onto a metal base substrate with a pattern of such as A1 or Cu to form a circuit. In this Reference, the insulating filler is formed of silica containing epoxy resin of 100 $\mu$ m thickness on which a foil consisting of aluminum or copper is formed as a wiring layer.

Patent Reference 2 discloses a metal thin film laminating ceramic substrate in which an electrically conductive layer consisting of Cu etc. is applied such as by pasting on a ceramic substrate consisting of AlN and is patterned to form a circuit and which can thereby be used as an IC package.

References cited:

   Patent Reference 1: Japanese Patent No. JP 3,156,798 B
   Patent Reference 2: Japanese Patent No. JP 2,762,007 B
   JP 2004-031485 A (Patent Reference 3) and JP 2004-119515 A (Patent Reference 4) each describe a metal-ceramic composite substrate according to the preamble of claim 1.

Disclosure of the Invention

Problems to be Solved by the Invention

By the way, in a semiconductor mounted circuit board as disclosed in Patent Reference 1 above, the use of a metal base substrate can improve the heat dissipation over a printed board but has the problem that because a wiring layer is formed on the silica containing epoxy resin as thick as 0.1 mm, the heat dissipation becomes comparatively low. Also, it is more expensive than the printed board but can be manufactured at a relatively low cost.

A ceramic substrate that has a high thermal conductivity such as AlN as according to Patent Reference 2 is better in heat dissipation than the printed board and also than the metal base substrate according to Patent Reference 1. There are, however, the problems that the need for a step of sintering the ceramic substrate itself makes the process complicated and the yield poor, thus making the cost of manufacture higher than the printed board and the metal base substrate of Patent Reference 1.

Further, the finer the circuit structure, eventually the larger in thermal resistance per volume becomes the ceramic substrate that is smaller in thermal conductivity than a metal substrate consisting of Cu or Al. Consequently, a micro circuit, e.g., a submount, which has a semiconductor device mounted thereon, has an AlN substrate amounting to 90 % in thermal resistance of the entire submount and thus becomes poor in heat dissipation and can not necessarily be said to be suitable in respect of this property.

In contrast, in a circuit board having a semiconductor device mounted thereon as an electronic device, apart from the requirement for low cost, the heat dissipation is given top priority so that a substrate that is yet lower in thermal resistance is desirable.

It is accordingly an object of the present invention to provide a metal-ceramic composite substrate having excellent heat dissipation.

It is another object of the present invention to provide a method of manufacturing a metal-ceramic composite substrate at low cost as mentioned above.

Means to Solve Problems

In order to attain the first-mentioned object mentioned above, there is provided in accordance with the present invention a metal-ceramic composite substrate comprising a metal substrate, a ceramic layer in the form of a thin film of a ceramic formed on the metal substrate, an electrode layer formed on the ceramic layer and a solder layer formed on the electrode layer, characterized in that a ceramic layer protective layer film is interposed between said ceramic layer and said electrode layer.

In the construction mentioned above, a further solder layer in addition to said solder layer is preferably formed directly on the said ceramic layer.

Said metal substrate preferably consists of copper or aluminum. Said ceramic layer preferably consists of a nitride ceramic, which is preferably aluminum nitride.

According to the present invention, using a metal preferably such as copper or aluminum for the metal substrate while forming on a surface of the metal substrate a thin film of a ceramic, preferably of nitride ceramic, in particular of aluminum nitride allows the surface of the metal substrate to be lowered in thermal resistance because of the ceramic thin film which itself is lower in thermal resistance. With the surface of the metal substrate reduced in thermal resistance, it follows, therefore, that the metal-ceramic composite substrate has the improved heat dissipation. Thus, permitting the metal substrate to become larger and a circuit to be formed which are high in thermal conductivity, a metal-ceramic composite substrate that is lower in thermal resistance than a ceramic substrate is provided.

In order to achieve the second-mentioned object mentioned above, the present invention also provides a method of manufacturing metal-ceramic composite substrate comprising a metal substrate, a ceramic layer formed on the metal substrate, an electrode layer formed on the ceramic layer and a solder layer formed on the electrode layer, wherein the method comprises the steps of: forming a thin film of a ceramic as said ceramic layer on said metal substrate; and forming a selected pattern of said electrode layer on said ceramic layer; characterized in that the method comprises the step of, subsequent to forming said ceramic layer, forming a ceramic layer protective film thereon.

The method of manufacturing in accordance with the present invention may further comprise the step of further forming a separate solder layer directly on said ceramic layer. The ceramic layer preferably consists of a nitride ceramic, in particular preferably of aluminum nitride.

According to the present invention, it is possible to make a metal-ceramic composite substrate that is lower in thermal resistance than a ceramic substrate, since it is permitted by using the substrate made of a metal and a ceramic thin film is formed on the surface of the metal substrate so that the volume of metal substrate having a high thermal conductivity becomes larger and a circuit can be formed. Further, the metal-ceramic composite substrate can be manufactured at low cost substantially as can be if the metal substrate is a metal base substrate and also since the ceramic thin film as the ceramic layer which can be formed, e.g., by PVD or the like process, requires no intricate process such as sintering, it follows that it as a whole can be manufactured at relatively low cost.

Effects of the Invention

According to the present invention, a metal-ceramic composite substrate that is low in thermal resistance is obtained which can be used with a semiconductor device to exhibit an improved heat dissipation as heat from the semiconductor device is transferred through the ceramic thin film that is low in thermal resistance, and then is dissipated from the metal substrate. Consequently, the metal-ceramic composite substrate of the present invention allows the semiconductor device to have a reduced temperature rise and improves the performance and the service life of a semiconductor device.

Further, a metal-ceramic composite substrate according to the present invention in which a metal substrate and a ceramic thin film on its surface are used can as a whole be manufactured at reduced cost.

Brief Description of the Drawings

Fig. 1 is a cross sectional view diagrammatically illustrating a structure of a metal-ceramic composite substrate;
Fig. 2 is a cross sectional view diagrammatically illustrating another structure of a metal-ceramic composite substrate;
Fig. 3 is a cross sectional view diagrammatically illustrating a structure in which a semiconductor device is mounted on a metal-ceramic composite substrate;
Fig. 4 is a cross sectional view diagrammatically illustrating the structure of a modification of the metal-ceramic composite substrate;
Fig. 5 is a cross sectional view diagrammatically illustrating the structure of another modification of the metal-ceramic composite substrate;
Fig. 6 is a cross sectional view diagrammatically illustrating the structure of a metal-ceramic composite substrate in accordance with the present invention;
Fig. 7 is a cross sectional view diagrammatically illustrating the structure of a modification of the metal-ceramic composite substrate in accordance with the present invention;
Fig. 8 is a cross sectional view diagrammatically illustrating a structure of Comparative Example 1; and

**EP 1 909 321 B1**

Fig. 9 is a cross sectional view diagrammatically illustrating a structure of Comparative Example 2.

<u>Explanation of Reference Characters</u>

10, 10A, 20, 20A, 30, 30A: metal-ceramic composite substrate
11, 61: metal substrate
12: ceramic layer (thin film of ceramic)
13, 52, 63: electrode layer
14, 53, 64: solder layer
15: semiconductor device
15A: upper electrode
15B: lower electrode
16: Au wire
22: solder layer (solder layer formed on ceramic layer)
24: ceramic layer protective film

<u>Best Modes for Carrying Out the Invention</u>

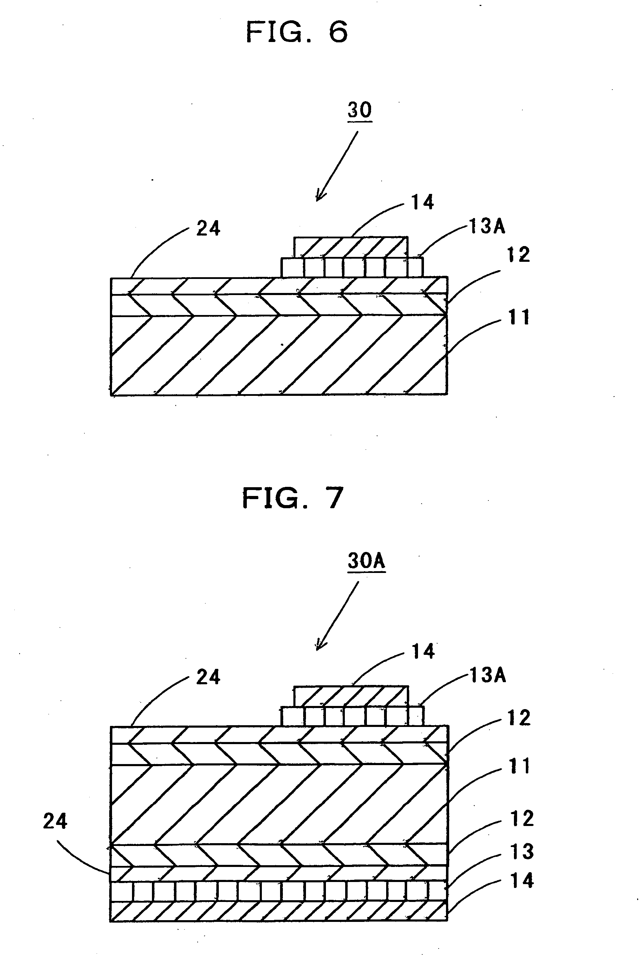

Hereinafter, forms of implementation of the present invention will be described in greater detail with particular reference to Figs. 6 to 9. In the Figures, identical reference characters are used to designate identical or corresponding parts or components.

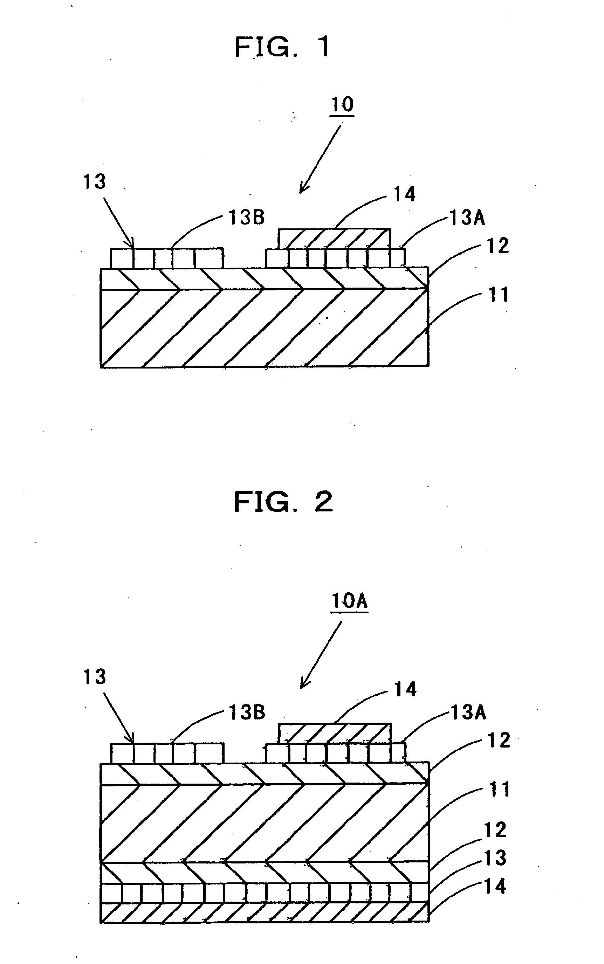

Figs. 1 and 2 are cross sectional views diagrammatically illustrating structures of a metal-ceramic composite substrate. In Fig. 1, a metal-ceramic composite substrate 10 is shown comprising a metal substrate 11; a ceramic layer 12 formed on one side of the metal substrate 11 so as to cover the entire metal substrate 11; an electrode layer 13 formed on a surface of the ceramic layer 12 so as to cover the surface in whole or in part; and a solder layer 14 formed on a selected portion 13A of the surface of the electrode layer 13.

Here, the selected portion 13A of the electrode layer 13 may be its whole surface in case of a light emitting diode or the like. There may be an electrode layer 13B where there is no solder layer. Such electrode layer 13B may have a pattern formed thereon or may have a portion to which a gold wire is connected to form an electrical circuit.

The metal substrate 11 may be provided at its rear side with the electrode layer 13 and the solder layer 14. The ceramic layer 12 may also be interposed between the rear side of the metal substrate 11 and the electrode and solder layers 13 and 14. In Fig. 2, a metal-ceramic composite substrate 10A is shown in which the ceramic layer 12, the electrode layer 13 and the solder layer 14 are deposited in order on the rear side of the metal substrate 11.

As the metal substrate 11, a metal base substrate consisting of a metal such as copper or aluminum may be used. Such a metal base substrate desirably has a thermal conductivity of, e.g., not less than 200 W/mK.

As the ceramic layer 12, a thin ceramic film that is excellent in adhesion to the metal substrate 11 can be used. Preferably, a nitride ceramic thin film such as aluminum nitride (AlN) having a low thermal resistance may be used.

As the electrode layer 13, a metal is desirably used, especially one of gold (Au), platinum (Pt), silver (Ag), copper (Cu), iron (Fe), aluminum (Al), titanium (Ti) and tungsten (W). It may also be an alloy containing any of these metals.

As for the solder layer 14, a solder is desirably used which does not contain lead (Pb), that is a Pb free solder. Further, a solder that contains two or more elements of the group consisting of silver, gold, copper, zinc (Zn), nickel (Ni), indium (In), gallium (Ga), bismuth (Bi), aluminum and tin (Sn) is preferably used.

Further, an adherence layer may be disposed between the metal substrate 11 and the ceramic layer 12 and/or between the electrode layer 13 and the solder layer 14 in order to raise adherence between the layers when formed. As the adherence layer, titanium can preferably be used.

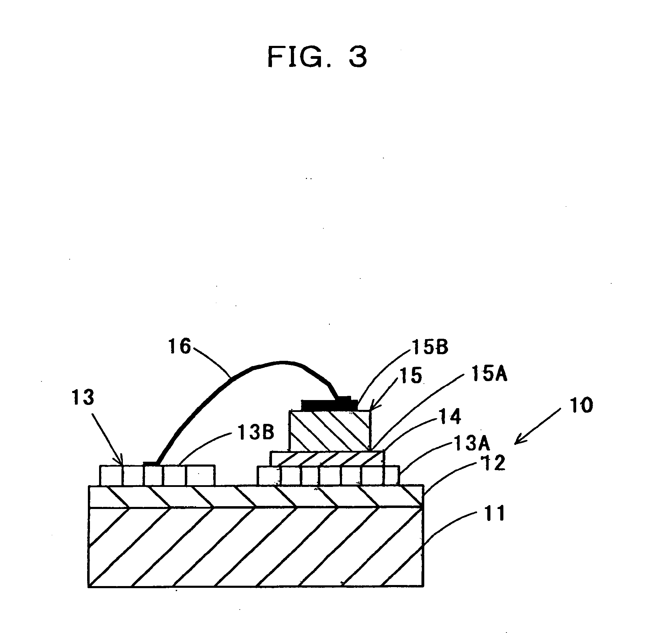

Mention is next made of an example in which a semiconductor device is mounted on a metal-ceramic composite substrate. Fig. 3 is a cross sectional view diagrammatically illustrating a structure in which a semiconductor device is mounted on the metal-ceramic composite substrate. As shown in Fig. 3, the semiconductor device 15 can be bonded at its lower electrode 15A by soldering to the metal-ceramic composite substrate 10 via the solder layer 14. Also, using the solder layer 14 consisting of an Au-Sn alloy permits bonding the semiconductor device 15 by soldering without any flux. On the other hand, as shown the semiconductor device 15 can at its upper electrode 15B be connected by wire bonding, via such as an Au wire 16 to above the left hand side electrode layer 13B insulated from the right hand side electrode layer 13A and having no solder layer formed thereon.

Here, the term "semiconductor device" (15) is used to mean a light emitting device such as laser diode or light emitting diode, an active element such as diode, or transistor or thyristor as used in high frequency amplification and switching, or an integrated circuit. While the semiconductor device 15 is shown in Fig. 2 as an electronic component to be mounted, it may be an electronic circuit containing a passive element or an active element of various kinds.

Mention is next made of the thermal resistance of a metal-ceramic composite substrate 10 having a semiconductor device mounted thereon. When the metal-ceramic composite substrate 10 has the metal substrate 11 mounted at its rear side on a package or heat sink and is with an area such as capable of mounting the semiconductor device 15 thereon, its thermal resistance $R_T$ can be calculated from equation (1) below.

$$R_T = \frac{1}{A}(\frac{t_M}{\kappa_M} + \frac{t_C}{\kappa_C} + \frac{t_E}{\kappa_E} + \frac{t_S}{\kappa_S}) + \frac{t_D}{A\kappa_D} + \frac{1}{4\pi\kappa_h} \qquad (1)$$

where the first term indicates the thermal resistance component of the metal-ceramic composite substrate 10; $t_M$, tc, $t_E$ and ts and $\kappa_M$, $\kappa_C$, $\kappa_E$ and $\kappa_S$ are the thicknesses and thermal conductivities of the metal substrate 11, the ceramic layer 12, the electrode layer 13A and the solder layer 14, respectively; and A is the area of the semiconductor device 15. The second term indicates the thermal resistance component of the semiconductor device 15; and $t_D$ and $\kappa_D$ are its junction depth and thermal conductivity. The third term indicates the thermal resistance component of the package or heat sink in which thermal conductivity is $\kappa_h$.

The thickness of the metal substrate 11 with the ease of its handling or the like taken into account is about 100 $\mu$ m to 1 mm whereas each of the ceramic layer 12, the electrode layer 13A and the solder layer 14 has its thickness generally of 10 $\mu$ m or less. Thus, equation (1) is approximated to equation (2) below.

$$R_T \cong \frac{1}{A}(\frac{t_M}{\kappa_M}) + \frac{t_D}{A\kappa_D} + \frac{1}{4\pi\kappa_h} \qquad (2)$$

For example, let it be assumed that the metal substrate 11 consists of copper (with $\kappa_M$ =300 W/mK) and its thickness $t_M$ is 500 $\mu$ m, that the ceramic layer 12 consists of aluminum nitride (with $\kappa_C$ = 200 W/mK) and its thickness tc is 10 $\mu$ m, that the electrode layer 13A consists of Au (with $\kappa_E$ = 315 W/mK) and its thickness $t_E$ is 0.1 $\mu$ m and that the solder layer 14 consists of Au-Sn (with $\kappa_S$ = 50 W/mK) and its thickness ts is 5 $\mu$ m.
Then, assuming the thermal resistance of the metal substrate 11 in the metal-ceramic composite substrate 10 to be 1 in equation (1) above, the thermal resistances of the ceramic layer 12, the electrode layer 13A and the solder layer 14 become about 0.03, 0.0002 and 0.06, respectively. The thermal resistances in these layers are greater in the order of the solder layer 14, the ceramic layer 12 and the electrode layer 13A. Yet, since the sum total of the thermal resistances of these layers amounts to about 1/15 of the metal substrate 11, it is seen that the thermal resistance of the metal-ceramic composite substrate 10 can be approximated by equation (2) above.

Mention is next made of the thermal resistance of a metal-ceramic composite substrate 10A. In this case, it is assumed that the ceramic layer 12, an electrode layer 13A and the solder layer 14 are provided also on the rear side of the metal substrate 11 as on its front side and are identical in material and thickness to those provided on the front side. The thermal resistance $R_T'$ of the metal-ceramic composite substrate 10A can be calculated by equation (3) below by adding to equation (1) above, the thermal resistance component by the ceramic layer 12, the electrode layer 13A and the solder layer 14 provided on the rear side of the metal substrate 11.

$$R_T' = \frac{1}{A}(\frac{t_M}{\kappa_M} + \frac{2t_C}{\kappa_C} + \frac{2t_E}{\kappa_E} + \frac{2t_S}{\kappa_S}) + \frac{t_D}{A\kappa_D} + \frac{1}{4\pi\kappa_h} \qquad (3)$$

In the thermal resistance $R_T'$ as in that $R_T$ of the metal-ceramic composite substrate 10 described above, the thermal resistance components by the ceramic layers 12, the electrode layers 13A and the solder layers 14 provided on both sides of the metal substrate 11 are sufficiently smaller than that of the metal substrate 11. Thus, the thermal resistance $R_T'$ of the metal-ceramic composite substrate 10A, too, in which the metal substrate 11 is provided on both its front and rear sides with the ceramic layer 12, the electrode layer 13A and the solder layer 14 can be approximated by equation (2) above.

Therefore, the metal-ceramic composite substrate 10 and 10A allows its thermal resistance to be determined by its thickest metal substrate 11 if the ceramic layer 12 is sufficiently thinner than the metal substrate 11. Consequently, the thermal resistance of the metal-ceramic composite substrate 10 becomes substantially identical to that of its metal substrate 11.

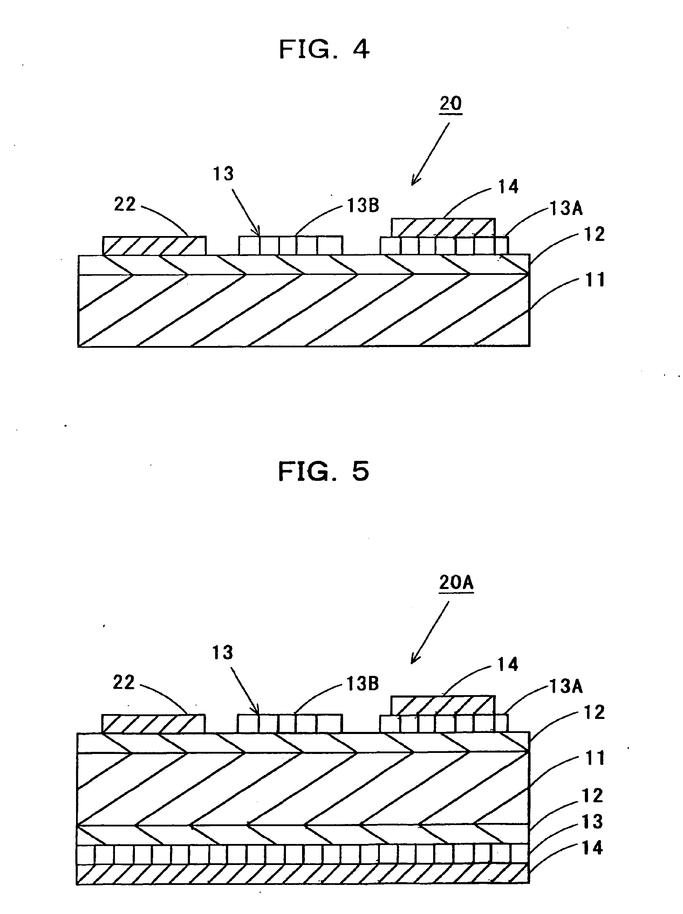

Mention is made of modifications of the metal-ceramic composite substrate. Figs. 4 and 5 are cross sectional views diagrammatically illustrating the structures of modifications of the metal-ceramic composite substrate, respectively. The metal-ceramic composite substrate 20 shown in Fig. 4 differs from the metal-ceramic composite substrate 10 shown in Fig. 1 in that a solder layer 22 separate from the solder layer 14 above is formed directly on the ceramic layer 12. The solder layer 22 may be connected to the electrode layer 13 to constitute an electrical circuit. It can also be patterned for wiring in order to mount other electronic circuit components. The solder layer 22 can be formed at the same time that the solder layer 14 is formed on the electrode layer 13.

The electrode layer 13 and the solder layer 14 can also be formed on the rear side of the metal substrate 11. The ceramic layer 12 may be interposed between the rear surface of the metal substrate 11 and the electrode and solder layers 13, 14. The metal-ceramic composite substrate 20A shown in Fig. 5 is an example in which the ceramic layer 12, the electrode layer 13 and the solder layer 14 are deposited in order on the rear side of the metal substrate 11.

Mention is made of an alternative modification 30 of the metal-ceramic composite substrate in accordance with the present invention.

Figs. 6 and 7 are cross sectional views diagrammatically illustrating the structures of alternative modifications of the metal-ceramic composite substrate in accordance with the present invention. The metal-ceramic composite substrate 30 shown in Fig. 6 differs from the metal-ceramic composite substrate 10 shown in Fig. 1 in that a ceramic layer protective film 24 is interposed between the ceramic layer 12 and the electrode layer 13.

The ceramic layer protective film 24 is a layer with which the ceramic layer 12 is first covered over its whole surface in the manufacture of the metal-ceramic composite substrate 30 of the present invention, and is provided to prevent the ceramic layer 12 from being etched or becoming larger in surface roughness by etching or the like in the step of patterning the electrode and solder layers 13 and 14. The ceramic layer protective film 24 can be removed of its extra portion after the solder layer 14 is formed to ensure its electrical insulation and separation from the electrode layer 13 formed on the metal-ceramic composite substrate 30.

Here, the ceramic layer protective film 24 is preferably composed of a metal which is adherent to the ceramic layer 12 and is different from that of the electrode layer 14. The ceramic layer protective film 24 can be made of titanium, platinum, nickel, tungsten, molybdenum (Mo), silver, copper, iron, aluminum or gold. It may contain two or more of such metals. For example, titanium can be deposited on the ceramic layer 12.

An electrode layer 13 and a solder layer 14 may also be provided on the rear surface of the metal substrate 11. A ceramic layer 12 may also be interposed between the rear surface of the metal substrate 11 and the electrode and solder layers, 13 and 14. In Fig. 7, a metal-ceramic composite substrate 30A is shown in which the ceramic layer 12, the electrode layer 13 and the solder layer 14 are deposited in order on the rear surface of the metal substrate 11.

In the metal-ceramic composite substrate 10, 20, 30, the ceramic layer 12 may be formed on the metal substrate 11 over its entire surface. At need, it may be formed on the metal substrate 11 only over a selected portion thereof. In this case, prior to forming the ceramic layer 12, patterning by photolithography is carried out. Thereafter, the ceramic layer (12) is deposited and then in the so-called lift-off process in which resist film used in the patterning is etched, the ceramic layer 12 can be formed only over a selected area. The ceramic layer 12 may also be deposited in the state that a metal mask opening at a selected portion is placed on the metal substrate 11. In this case, the ceramic layer 12 is only formed at the opening portion of the metal mask.

The ceramic layer 12, the electrode layer 13 and the solder layer 14 as shown at the metal-ceramic composite substrate 10A, 20A, 30A may be provided not only on one side, namely on the front surface but also on the rear surface as well, namely on each of both sides of the metal substrate 11. At need, the ceramic layer protective layer 24 may be interposed between the ceramic layer 12 and the electrode layer 13.

The ceramic layer 12 has the form of a ceramic thin film having an excellent heat dissipation property and is formed onto the surface of the low cost metal substrate 11. According to the metal-ceramic composite substrate 10, 10A, 20, 20A, 30, 30A, the ability to form a joining area small in thermal resistance allows reducing the thermal resistance of a semiconductor device using the metal-ceramic composite substrate 10, 10A, 20, 20A, 30, 30A, thereby improving the performance and service life of the semiconductor device.

Mention is next made of a method of manufacture a metal-ceramic composite substrate.

First, a metal substrate 11 is prepared and its both sides are polished. The polished metal substrate 11 is washed to perform its surface cleaning. Thereafter, an AlN thin film as ceramic layer 12 is formed on a surface of the metal substrate 11. The ceramic layer 12 can be formed by, e.g., PVD (physical vapor deposition) or CVD (chemical vapor deposition).

Subsequently, patterning by photolithography is effected. Specifically, after a resist is applied uniformly over an entire upper surface of the metal substrate 11 with a spinner, it is baked as desired in a baking furnace and then is subjected to contact exposure using a mask aligner.

After the exposure, a portion of the resist where an electrode layer 13 is to be formed is dissolved using a developer of tetramethylamine family to expose the ceramic layer 12.

Next, the electrode layer 13 is formed on the ceramic layer 12 by a lift-off process. Specifically, the resist in the form of a film formed in a patterning process as mentioned above is removed together with a metal layer vapor deposited on the resist film by a resist stripping agent and utilizing swelling of the resist film. This allows the electrode layer 13 to be formed having a given pattern on the ceramic layer 12. The resist stripping agent used may be acetone, isopropyl alcohol or the like conventional resist stripping agent.

As in the process of forming the electrode layer 13, a lift-off process is then performed using photolithography and vacuum vapor deposition equipment to form a solder layer 14 on a portion of the electrode layer 13 formed on the surface of the metal substrate 11.

The metal substrate 11 obtained is cut into a desired size of the submount 10 with a dicing machine. This completes forming a metal-ceramic composite substrate 10.

In the case of a metal-ceramic composite substrate 20, a solder layer 22 may be formed on the ceramic layer 12 at the same time that the solder layer 14 is formed on the electrode layer 13.

In the case of a metal-ceramic composite substrate 30 in accordance with the present invention, after forming the ceramic layer 12, a metal film to become a ceramic layer protective film 24 is formed on the ceramic layer 12 over its entire surface. The subsequent process can be carried out as in forming the metal-ceramic composite substrate 10. After forming the solder layer 14, an extra portion of the ceramic layer protective film 24 may be removed by etching at need.

Also, in the case of a metal-ceramic composite substrate 10A, 20A, 30A, its manufacture requires that not only on the front side of the metal substrate but also further on the rear side by the process as in the front side of the metal substrate 11, the ceramic layer 12, the electrode layer 13 and the solder layer 14 be provided. At need, the ceramic layer protective film 24 in accordance with the present invention may be interposed between the ceramic layer 12 and the electrode layer 13.

One aspect of the method of manufacturing the metal-ceramic composite substrate 10, 10A, 20, 20A, 30, 30A resides in forming the ceramic thin film 12 such as of AlN on the front side of the metal substrate such as of Cu or Al or on each of its front and rear surfaces, namely of both sides. The method of manufacturing the metal-ceramic composite substrate 10, 10A, 20, 20A, 30, 30A permits reducing the thermal resistance with a semiconductor device 15, thereby making it possible for a metal-ceramic composite substrate excellent in heat dissipating property to be manufactured at a reduced cost and improved yield.

[Example]

The present invention will be described in further detail with reference to a specific example thereof.

First, mention is made of a method of manufacturing a metal-ceramic composite substrate 30A as Example.

A metal substrate 11 consisting of Cu and having a size of 50 mm x 50 mm, a thickness of 300 $\mu$m and a thermal conductivity of 300 W/mK was washed on its both surfaces to effect its surface cleaning. A ceramic layer 12 consisting of AlN and having a thickness of 10 $\mu$m was formed by PVD over its entire front and rear surfaces. For performing the PVD, a sputtering equipment was used. Using Al as a target further with concurrent supply of a nitrogen gas allowed an AlN thin film 12 to be deposited. The AlN thin film has a thermal conductivity of 200 W/mK.

Next, Ti which was to become the ceramic layer protective film 24 and of a thermal conductivity of 20 W/mK was deposited to a thickness of 0.05 $\mu$m by a vacuum vapor deposition equipment on the AlN thin film 12 over its entire front and rear surfaces.

In order to effect patterning by photolithography, a resist was applied using a spinner uniformly over an entire surface of the metal substrate 11 formed with the AlN thin film 12 and the ceramic layer protective film 24 whereafter it was baked as desired in a baking furnace and then is subjected to a $\gamma$ ray contact exposure using a mask aligner. A mask for the exposure has a submount size of 1 mm square and was designed so that a number of 2,500 pieces can simultaneously be patterned.

After the exposure, a portion of the resist where the electrode layer 13 is to be formed was dissolved using a developer of tetramethylamine family to expose the ceramic layer protective film 24. Then, the ceramic layer protective film 24 on the rear surface of the metal substrate 11 was not patterned.

Gold of 315 W/mK in thermal conductivity was vapor deposited by the vacuum vapor deposition equipment on the ceramic layer protective film 24 formed on each of the front and rear surfaces of the metal substrate 11, and a lift-off process was performed on the resist pattern formed on the ceramic layer protective film 24 on the front side of the metal substrate 11. Specifically, the resist entirely was dissolved using acetone to remove Au other than for the electrode layer 13 and to form the electrode layer 13 as desired. The electrode layer 13 had a thickness of 0. $\mu$m and a size of 800 $\mu$m square on both sides.

Using the photolithography and the vacuum vapor deposition equipment as for the electrode layer 13, a solder layer 14 having a thickness of 5 $\mu$m was formed in a lift-off process on a portion of the electrode layer 13 formed on the surface of the metal substrate 11. The solder layer 14 was composed of $Au_{0.8}Sn_{0.2}$ (in atomic ratio) having a thermal conductivity of 50 W/mK. The solder layer 14 had a size of 500 $\mu$ m square at its joining area with the semiconductor device and a size of 800 $\mu$ m square at its joining area with the submount. Then, the solder layer 14 on the Au layer provided on the rear surface of the metal substrate 11 was not patterned.

The metal substrate 11 obtained was cut into 1 mm square using a dicing machine and a metal-ceramic composite substrate 30A of Example was thus made.

Mention is next made of comparative examples.

(Comparative Example 1)

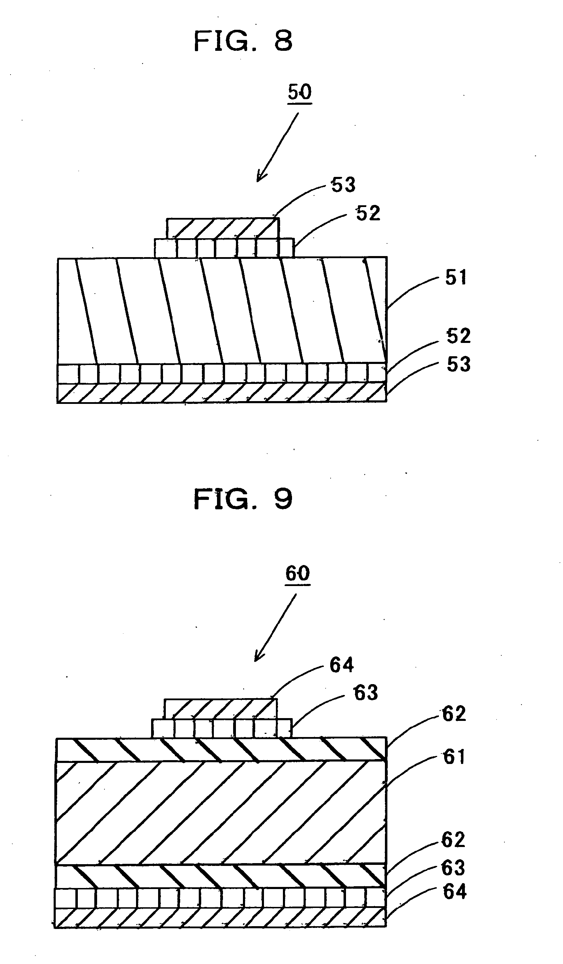

As shown in Fig. 8, on each of the front and rear surfaces of a ceramic substrate 51 having a thermal conductivity of 200 W/mK and a thickness of 520 $\mu$ m and consisting of AlN, a Ti film having a thickness of 0.05 $\mu$ m, an electrode layer 52 having a thickness of 0.1 $\mu$m and consisting of Au and a solder layer 53 having a thickness of 5 $\mu$m and consisting of $Au_{0.8}Sn_{0.2}$ (in atomic ratio) were formed by vapor deposition to make a circuit board 50 with the ceramic substrate. The size of the ceramic substrate 51 and the pattern size of the electrode and solder layers 52, 53 formed on its front side were identical to those in Example.

(Comparative Example 2)

As shown in Fig. 9, the circuit board 60 was fabricated as follows. The insulating layer 62 of filler (10 W/mK) having a thickness of 10 $\mu$ m was formed onto each of both sides of a metal substrate 61 having a thermal conductivity of 300 W/mK and a thickness of 500 $\mu$ m. Ti film having a thickness of 0.05 $\mu$ m, the electrode layer 63 of Au having a thickness of 0.1 $\mu$ m and the solder layer 64 of $Au_{0.8}Sn_{0.2}$ (in atomic ratio) having a thickness of 5 $\mu$ m were formed by vapor deposition onto the insulating layer 62. The size of the metal substrate 61 and the pattern size of the electrode and solder layers 63, 64 formed on its front side were identical to those in Example.

Mention is made below of properties of the metal-ceramic composite substrate 30A of Example and the circuit boards 50 and 60 of Comparative Examples 1 and 2.

A light emitting diode was bonded to the metal-ceramic composite substrate 30A made in Example and the circuit boards 50 and 60 made in Comparative Examples 1 and 2 via their respective solder layers and after they have current passed therethrough, their temperature rises and thermal resistances were measured (see Table 1).

Table 1

|  | Temperature Rise (℃) | Thermal Resistance (℃/W) |
|---|---|---|
| Example | 3.0 | 2.0 |
| Comparative Example 1 | 4.2 | 2.8 |
| Comparative Example 2 | 5.8 | 3.9 |

It is seen that the metal-ceramic composite substrate 30A in Example 1 has a thermal resistance of 2.0°C /W and a temperature difference between temperatures at the chip side temperature and heat dissipating side of 3.0°C. In contrast, the circuit board 50 in Comparative Example 1 has a thermal resistance of 2.8°C/W and a temperature difference between temperatures at the chip side temperature and heat dissipating side of 4.2°C. And, the circuit board 60 in Comparative Example 2 has a thermal resistance of 3.9°C/W and a temperature difference between temperatures at the chip side temperature and heat dissipating side of 5.8°C.

The Example and Comparative Examples above indicate that when having a semiconductor device 15 mounted thereon, a metal-ceramic composite substrate 30A in which a metal substrate 11 is formed on a surface thereof with a ceramic layer 12 in the form of a ceramic thin film can be obtained which is at a reduced cost and low in thermal resistance as well.

The present invention in its applications is not limited to the use of a light emitting diode as described in the Example above but is applicable to the use of a semiconductor device or circuit component having an electrode on its rear side. The present invention allows various modifications within the scope of the invention set forth in the claims and it is needless to say that they should be included by the coverage of the present invention. For example, the semiconductor device is not limited to a light emitting diode. Further, although as the metal substrate 11, mention was made of Al or Cu used, the metal substrate 11 may be composed of any other suitable metal.

While in the forms of implementation described above, the ceramic layer 12 is shown composed of AlN, this is not a limitation and it may be composed of any other suitable ceramic material. Further, the pattern of an electrode layer 13 and/or a solder layer 14 may fittingly be designed so as to meet a targeted circuit configuration.

**Claims**

1. A metal-ceramic composite substrate comprising a metal substrate (11), a ceramic layer (12) in the form of a thin film of a ceramic formed on the metal substrate (11), an electrode layer (13) formed on the ceramic layer (12) and a solder layer (14) formed on the electrode layer (13), **characterized in that** a ceramic layer protective film (24) is interposed between said ceramic layer (12) and said electrode layer (13).

2. The metal-ceramic composite substrate as set forth in claim 1, **characterized in that** a further solder layer (22) is formed directly on said ceramic layer (12).

3. The metal-ceramic composite substrate as set forth in claim 1, **characterized in that** said metal substrate (11) consists of copper or aluminum.

4. The metal-ceramic composite substrate as set forth in any one of claims 1 to 3, **characterized in that** said ceramic layer (12) consists of a nitride ceramic.

5. The metal-ceramic composite substrate as set forth in claim 4, **characterized in that** said nitride ceramic is aluminum nitride.

6. A method of manufacturing a metal-ceramic composite substrate comprising a metal substrate (11), a ceramic layer (12) formed on the metal substrate (11), an electrode layer (13) formed on the ceramic layer (12) and a solder layer (14) formed on the electrode layer (13), wherein the method comprises the steps of:

   forming a thin film of a ceramic as said ceramic layer (12) on said metal substrate (11); and
   forming a selected pattern of said electrode layer (13) on said ceramic layer (12);
   **characterized in that** the method comprises the step of, subsequent to forming said ceramic layer (12), forming a ceramic layer protective film (24) thereon.

7. The method of manufacturing a metal-ceramic composite substrate as set forth in claim 6, **characterized in that** it further comprises the step of further forming a separate solder layer (22) directly on said ceramic layer (12).

8. The method of manufacturing a metal-ceramic composite substrate as set forth in claim 6 or claim 7, **characterized in that** said ceramic layer (12) consists of a nitride ceramic.

9. The method of manufacturing a metal-ceramic composite substrate as set forth in claim 8, **characterized in that** said nitride ceramic is aluminum nitride.

**Patentansprüche**

1. Metall-Keramik-Verbundsubstrat mit einem Metallsubstrat (11), einer Keramikschicht (12) in Form eines dünnen Keramikfilms, welcher auf dem Metallsubstrat (11) gebildet ist, mit einer Elektrodenschicht (13), welche auf der Keramikschicht (12) gebildet ist und einer Lötmittelschicht (14), welche auf der Elektrodenschicht (13) gebildet ist, **dadurch gekennzeichnet, dass** zwischen der Keramikschicht (12) und der Elektrodenschicht (13) ein die Keramikschicht schützender Film (24) zwischen gesetzt ist.

2. Metall-Keramik-Verbundsubstrat nach Anspruch 1, **dadurch gekennzeichnet, dass** eine weitere Lötmittelschicht (22) direkt auf der Keramikschicht (12) angeordnet ist.

**3.** Metall-Keramik-Verbundsubstrat nach Anspruch 1, **dadurch gekennzeichnet, dass** das Metallsubstrat (11) aus Kupfer oder Aluminium besteht.

**4.** Metall-Keramik-Verbundsubstrat nach einem der Ansprüche 1 bis 3, **dadurch gekennzeichnet, dass** die Keramiklage (12) aus einer Nitridkeramik besteht.

**5.** Metall-Keramik-Verbundsubstrat nach Anspruch 4, **dadurch gekennzeichnet, dass** die Nitrid-Keramik ein Aluminiumnitrid ist.

**6.** Verfahren zum Herstellen eines Metall-Keramik-Verbundsubstrats, mit einem Metallsubstrat (11), einer Keramikschicht (12), welche auf dem Metallsubstrat (11) gebildet ist, einer Elektrodenschicht (13), welche auf der Keramikschicht (12) gebildet ist und einer Lötmittelschicht (14), welche auf der Elektrodenschicht (13) gebildet ist, mit folgenden Schritten:

Bilden eines dünnen Keramikfilms als Keramikschicht (12) auf dem Metallsubstrat (11); und
Bilden eines ausgewählten Musters der Elektrodenschicht (13) auf der Keramikschicht (12),
**dadurch gekennzeichnet, dass** das Verfahren dem Schritt Formen der Keramikschicht (12) folgend den Schritt Formen eines die Keramikschicht schützenden Films (24) hierauf aufweist.

**7.** Verfahren zum Herstellen eines Metall-Keramik-Verbundsubstrats nach Anspruch 6, **dadurch gekennzeichnet, dass** er folgenden Schritt aufweist:

Bilden einer separaten Lötmittelschicht (22) direkt auf der Keramikschicht (12).

**8.** Verfahren zum Herstellen eines Metall-Keramik-Verbundsubstrats nach Anspruch 6 oder Anspruch 7, **dadurch gekennzeichnet, dass** die Keramikschicht (12) aus einer Nitrid-Keramik besteht.

**9.** Verfahren zum Herstellen eines Metall-Keramik-Verbundsubstrats nach Anspruch 8, **dadurch gekennzeichnet, dass** die Nitrid-Keramik ein AluminiumNitrid ist.

**Revendications**

**1.** Substrat composite métal céramique comportant un substrat métallique (11), une couche de céramique (12) sous la forme d'une couche mince réalisée à partir d'une céramique formée sur la couche métallique (11), une couche d'électrode (13) formée sur la couche de céramique (12) et une couche de brasure (14) formée sur la couche d'électrode (13), **caractérisé en ce qu'**une pellicule de protection (24) de la couche de céramique se trouve intercalée entre ladite couche de céramique (12) et ladite couche d'électrode (13).

**2.** Substrat composite métal céramique selon la revendication 1, **caractérisé en ce qu'**une autre couche de brasure (22) est formée directement sur ladite couche de céramique (12).

**3.** Substrat composite métal céramique selon la revendication 1, **caractérisé en ce que** ledit substrat métallique (11) est constitué de cuivre ou d'aluminium.

**4.** Substrat composite métal céramique selon l'une quelconque des revendications 1 à 3, **caractérisé en ce que** ladite couche de céramique (12) est constituée d'une céramique de nitrure.

**5.** Substrat composite métal céramique selon la revendication 4, **caractérisé en ce que** ladite céramique de nitrure est du nitrure d'aluminium.

**6.** Procédé de fabrication d'un substrat composite métal céramique comportant un substrat métallique (11), une couche de céramique (12) formée sur le substrat métallique (11), une couche d'électrode (13) formée sur la couche de céramique (12) et une couche de brasure (14) formée sur la couche d'électrode (13), dans lequel le procédé comporte les étapes consistant à :

former une couche mince réalisée à partir d'une céramique telle ladite couche de céramique (12) sur ledit substrat métallique (11) ; et

former une configuration sélectionnée de ladite couche d'électrode (13) sur ladite couche de céramique (12) ; **caractérisé en ce que** le procédé comporte l'étape consistant à, suite à la formation de ladite couche de céramique (12), former une pellicule de protection (24) de la couche de céramique sur celle-ci.

7. Procédé de fabrication d'un substrat composite métal céramique selon la revendication 6, **caractérisé en ce qu'**il comporte par ailleurs l'étape consistant à former une couche de brasure (22) séparée directement sur ladite couche de céramique (12).

8. Procédé de fabrication d'un substrat composite métal céramique selon la revendication 6 ou la revendication 7, **caractérisé en ce que** ladite couche de céramique (12) est constituée d'une céramique de nitrure.

9. Procédé de fabrication d'un substrat composite métal céramique selon la revendication 8, **caractérisé en ce que** ladite céramique de nitrure est du nitrure d'aluminium.

# FIG. 1

# FIG. 2

# FIG. 3

# FIG. 4

# FIG. 5

# FIG. 6

# FIG. 7

# FIG. 8

<u>50</u>

53
52
51
52
53

# FIG. 9

<u>60</u>

64
63
62
61
62
63
64

**EP 1 909 321 B1**

**REFERENCES CITED IN THE DESCRIPTION**

**Patent documents cited in the description**

- JP 3156798 B
- JP 2762007 B
- JP 2004031485 A
- JP 2004119515 A